(19) Europäisches Patentamt European Patent Office Office européen des brevets

(11) **EP 4 106 099 B1**

(12) **EUROPEAN PATENT SPECIFICATION**

(45) Date of publication and mention of the grant of the patent:
**04.03.2026 Bulletin 2026/10**

(21) Application number: **22163739.0**

(22) Date of filing: **23.03.2022**

(51) International Patent Classification (IPC):
**H01P 11/00** $^{(2006.01)}$

(52) Cooperative Patent Classification (CPC):
**H01P 11/008; H01P 11/007**

(54) **MILLIMETER WAVE COMPONENTS IN A GLASS CORE OF A SUBSTRATE**

MILLIMETERWELLENKOMPONENTEN IN EINEM GLASKERN EINES SUBSTRATS

COMPOSANTS D'ONDES MILLIMÉTRIQUES DANS UN NOYAU DE VERRE D'UN SUBSTRAT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.06.2021 US 202117350184**

(43) Date of publication of application:
**21.12.2022 Bulletin 2022/51**

(73) Proprietor: **INTEL Corporation Santa Clara, CA 95054 (US)**

(72) Inventors:
- **KAMGAING, Telesphor Chandler, AZ 85249 (US)**
- **ALEKSOV, Aleksandar Chandler, AZ 85286 (US)**
- **DOGIAMIS, Georgios C. Chandler, AZ 85226 (US)**
- **STRONG, Veronica Brussels 1040 (BE)**
- **PRABHU GAUNKAR, Neelam Chandler, AZ 85226 (US)**

(74) Representative: **HGF HGF Limited 4th Floor, 1 City Square Leeds LS1 2ES (GB)**

(56) References cited:
**US-A1- 2010 096 174    US-A1- 2014 361 854 US-A1- 2017 186 710**

- **SANMING HU ET AL: "Millimeter-wave/THz passive components design using through silicon via (TSV) technology", ELECTRONIC COMPONENTS AND TECHNOLOGY CONFERENCE (ECTC), 2010 PROCEEDINGS 60TH, IEEE, PISCATAWAY, NJ, USA, 1 June 2010 (2010-06-01), pages 520 - 523, XP031694142, ISBN: 978-1-4244-6410-4**

## Description

### FIELD

Embodiments of the present disclosure generally relate to the field of semiconductor packaging, and in particular to millimeter wave components within a package core.

### BACKGROUND

Continued growth in virtual machines and cloud computing will continue to increase the demand for reduced size and higher capacity semiconductor packages.
US20140361854A1 relates to systems, methods and apparatus for a compact 3-D coplanar transmission line (CTL).
US20170186710A1 relates to integrated high quality electronic components and systems, and methods of their manufacture.
US2010/096174A1 relates to a filter circuit element and electronic circuit device.
SANMING HU ET AL: "Millimeter-wave/THz passive components design using through silicon via (TSV) technology", ELECTRONIC COMPONENTS AND TECHNOLOGY CONFERENCE (ECTC), 2010 PROCEEDINGS 60th, IEEE, PISCATAWAY, NJ, USA, 1 June 2010 (2010-06-01), pages 520-523, XP031694142, ISBN: 978-1-4244-6410-4 relates to 3-D integration using through silicon vias (TSVs).

### BRIEF DESCRIPTION OF THE DRAWINGS

FIG. 1 illustrates multiple examples of laser-assisted etching of glass interconnects processes, in accordance with various embodiments.
FIG. 2 illustrates a side view of a package that includes bandpass filters within in a glass core, in accordance with various embodiments.
FIGs. 3A-3C illustrate a cross-section of different types of resonators within a glass core, in accordance with various embodiments.
FIG. 4 illustrates a top view example of a conventional strip line implementation of a directional coupler.
FIG. 5 illustrates a side view of a directional coupler within a glass core, in accordance with various embodiments.
FIG. 6 illustrates top views of a circulator that includes a ferrite and strip line junction with examples of circulation of an input signal, in accordance with various embodiments.
FIGs. 7A-7C illustrate various portions within a process of creating a circulator, in accordance with various embodiments.

FIG. 8 illustrates an example process to create a resonator in a glass core, in accordance with various embodiments.
FIG. 9 schematically illustrates a computing device, in accordance with embodiments.

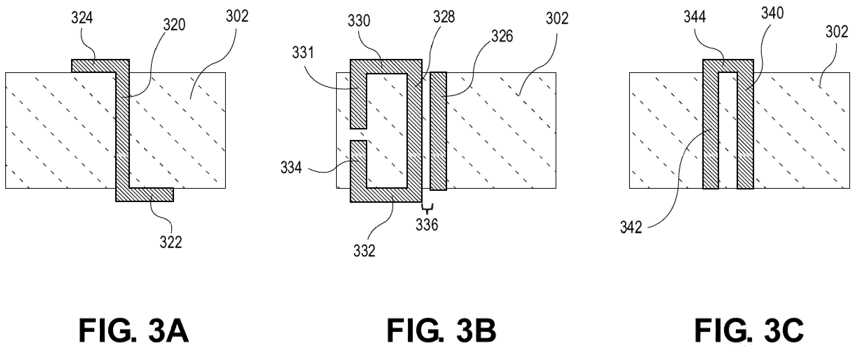

The invention as defined by the appended claims is directed to the ring resonator embodiment of fig. 3B. The other embodiments are not encompassed by the wording of the appended claims but are considered as useful for understanding the invention.

### DETAILED DESCRIPTION

Embodiments described herein may be related to apparatuses, processes, and techniques for creating millimeter wave components within a glass core of a substrate within a semiconductor package. These millimeter wave components may be combined to form other structures such as filters or multiplexers at least partially within the glass core. Laser etching of glass interconnects techniques described herein enable high aspect ratio, vertical, and narrow structures to be created within glass cores.

Vertical orientations of millimeter wave components will also reduce the overall footprint required for these components as compared to legacy implementations. Examples of millimeter
wave components include directional couplers, resonators, isolators, circulators, filters, resonance cavities, mm-Wave capacitors, inductors and transformers and the like. Embodiments may result in component footprint reduction, ease of integration by utilizing laser-etch process to build vertical components without the need of additional process steps, multiplexing solutions implemented within low-loss cores, and the ability to satisfy higher bandwidth densities with a reduction in insertion loss, with respect to legacy implementations. Embodiments described herein may enable system-level solutions in sub-terahertz (Thz) frequencies and beyond.

With a surge in demand for high-speed communication services, low latency solutions with high data rates and bandwidth density have emerged. At millimeter wave frequencies, components such as resonators, couplers, isolators and circulators serve as building blocks for system-level implementations. Additionally, some of these components, for example, resonators, can be combined to form bandpass filters. A combination of bandpass filters also known as multiplexers, are necessary to meet the metrics of high bandwidth density or high data rates.

In legacy implementations, millimeter wave components are implemented as standalone components external to a package. At millimeter wave frequencies, such legacy structures can be implemented on package within a build up layer, with a tradeoff of higher losses with relatively larger footprints within the package, as compared to embodiments described herein. Legacy implementations as standalone components add to the overall loss budget and form factor of the system. In addition, in-package legacy integrated components may be impacted by design rules for minimum coupling distance and/or process tolerances. Additionally, legacy implementations may involve integration of magnetic materials for circulators, which requires use of additional area within the package.

In embodiments, one or more laser sources followed by wet-etching may be used to create through hole vias or trenches into the glass panel or glass wafer. Using these laser techniques, vias may be created with a small diameter, for example on the order of less than 20 $\mu$m, and may be spaced with a pitch on the order of 50 $\mu$m or less. Other vias may be created with different diameter sizes. These vias may be later plated or filled to create electrical pathways through the bridge. These techniques may be used to create vias in the glass wafer or panel that have high aspects ratios, for example 40:1 or 50:1. Because of the fine pitch of the vias, more signals may be put through the BGA field at a higher density and may expand the frequency range resulting in a higher bandwidth communications. In addition, these techniques may reduce or eliminate impedance mismatch, which in legacy implementations may limit the frequency bandwidth of signals transmitted through the package BGA interface.

In the following detailed description, reference is made to the accompanying drawings which form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

Various operations may be described as multiple discrete operations in turn, in a manner that is most helpful in understanding the claimed subject matter. However, the order of description should not be construed as to imply that these operations are necessarily order dependent.

As used herein, the term "module" may refer to, be part of, or include an ASIC, an electronic circuit, a processor (shared, dedicated, or group) and/or memory (shared, dedicated, or group) that execute one or more software or firmware programs, a combinational logic circuit, and/or other suitable components that provide the described functionality.

Various Figures herein may depict one or more layers of one or more package assemblies. The layers depicted herein are depicted as examples of relative positions of the layers of the different package assemblies. The layers are depicted for the purposes of explanation, and are not drawn to scale. Therefore, comparative sizes of layers should not be assumed from the Figures, and sizes, thicknesses, or dimensions may be assumed for some embodiments only where specifically indicated or discussed.

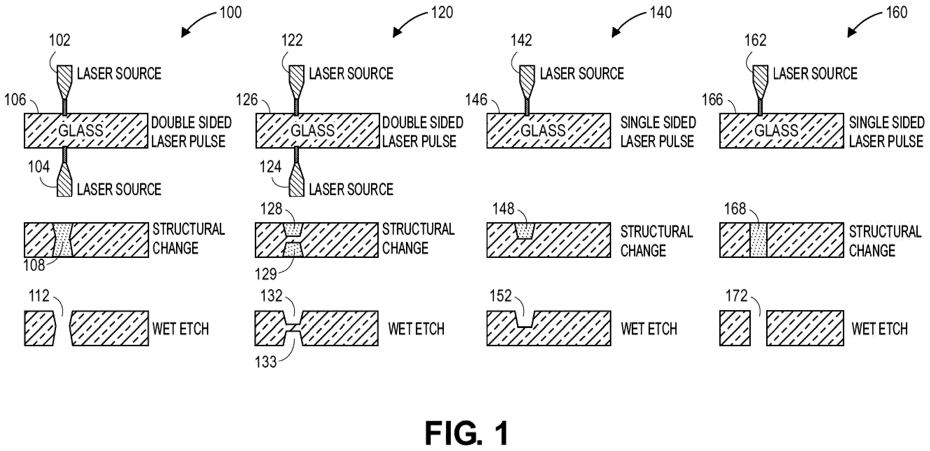

FIG. 1 illustrates multiple examples of laser-assisted etching of glass interconnects processes (which may be referred to as "LEGIT" herein), in accordance with embodiments. One use of the LEGIT technique is to provide an alternative substrate core material to the legacy copper clad laminate (CCL) core used in semiconductor packages used to implement products such as servers, graphics, clients, 5G, and the like. By using laser-assisted etching, crack free, high density via drills, hollow shapes may be formed into a glass substrate. In embodiments, different process parameters may be adjusted to achieve drills of various shapes and depths, thus opening the door for innovative devices, architectures, processes, and designs in glass. Embodiments, such as the bridge discussed herein, may also take advantage of these techniques.

Diagram 100 shows a high level process flow for a through via and blind via (or trench) in a microelectronic package substrate (e.g. glass) using LEGIT to create a through via or a blind via. A resulting volume/shape of glass with laser-induced morphology change that can then be selectively etched to create a trench, a through hole or a void that can be filled with conductive material. A through via 112 is created by laser pulses from two laser sources 102, 104 on opposite sides of a glass wafer 106. As used herein, a through drill and a through via refers to when the drill or the via starts on one side of the glass/-substrate and ends on the other side. A blind drill and a blind via refers to when the drill or the via starts on the surface of the substrate and stops partially inside the substrate. In embodiments, the laser pulses from the two laser sources 102, 104 are applied perpendicularly to the glass wafer 106 to induce a morphological change 108, which may also be referred to as a structural change, in the glass that encounters the laser pulses. This morphological change 108 includes changes in the molecular structure of the glass to make it easier to etch out (remove a portion of the glass). In embodiments, a wet etch process may be used.

Diagram 120 shows a high level process flow for a double blind shape. A double blind shape 132, 133 may be created by laser pulses from two laser sources 122, 124, which may be similar to laser sources 102, 104, that are on opposite sides of the glass wafer 126, which may be similar to glass wafer 106. In this example, adjustments may be made in the laser pulse energy and/or the laser pulse exposure time from the two laser sources 122, 124. As a result, morphological changes 128, 129 in the glass 126 may result, with these changes making it easier to etch out portions of the glass. In embodiments, a wet etch process may be used.

Diagram 140 shows a high level process flow for a single-blind shape, which may also be referred to as a trench. In this example, a single laser source 142 delivers a laser pulse to the glass wafer 146 to create a morphological change 148 in the glass 146. As described above, these morphological changes make it easier to etch out a portion of the glass 152. In embodiments, a wet etch process may be used.

Diagram 160 shows a high level process flow for a through via shape. In this example, a single laser source 162 applies a laser pulse to the glass 166 to create a morphological change 168 in the glass 166, with the change making it easier to etch out a portion of the glass 172. As shown here, the laser pulse energy and/or laser pulse exposure time from the laser source 162 has been adjusted to create an etched out portion 172 that extends entirely through the glass 166.

With respect to FIG. 1, although embodiments show laser sources 102, 104, 122, 124, 142, 162 as perpendicular to a surface of the glass 106, 126, 146, 166, in embodiments, the laser sources may be positioned at an angle to the surface of the glass, with pulse energy and/or pulse exposure time variations in order to cause a diagonal via or a trench, or to shape the via, such as 112, 172, for example to make it cylindrical, tapered, or include some other feature. In addition, varying the glass type may also cause different features within a via or a trench as the etching of glass is strongly dependent on the chemical composition of the glass.

In embodiments using the process described with respect to FIG. 1, through hole vias 112, 172 may be created that are less than 10 $\mu$m in diameter, and may have an aspect ratio of 40:1 to 50:1. As a result, a far higher density of vias may be placed within the glass and be placed closer to each other at a fine pitch. In embodiments, this pitch may be 50 $\mu$m or less. After creating the vias or trenches, a metallization process may be applied in order to create a conductive pathway through the vias or trenches, for example a plated through hole (PTH). Using these techniques, finer pitch vias will result in better signaling, allowing more I/O signals to be put through the glass wafer and to other coupled components such as a substrate.

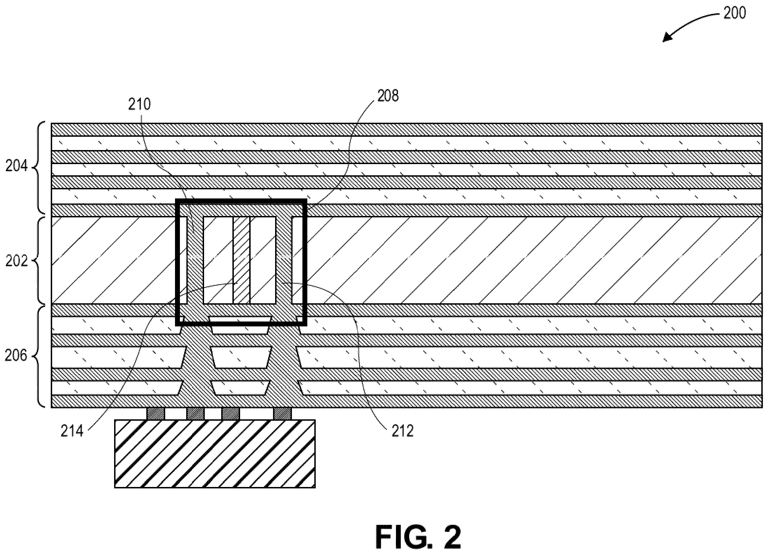

FIG. 2 illustrates a side view of a package that includes bandpass filters, or other components described as embodiments herein, within in a glass core, in accordance with various embodiments. Package 200 includes a glass core 202 with buildup layers 204, 206 on either side of the glass core 202. An embedded component 208 within the glass core 202 may include multiple millimeter wave components 210, 212. Millimeter wave components 210, 212 may include resonators, isolators, directional couplers, circulators, and the like. In embodiments, a reference ground plane 214 may also be included with the embedded component 208.

In embodiments, the reference ground plane 214 acts as a reference plane for embedded components such as the filters, resonators etc. as described herein. This reference plane 214 may be placed on either/both sides of the embedded component 208 or millimeter wave components 210, 212 and defines the impedance of the transmission lines used to create the millimeter wave components.

Subsequent figures and associated descriptions refer to the design of three different millimeter wave components 210, 212, in particular resonators, directional couplers, and circulators, and how they may be created using laser-assisted etching techniques described herein. Some of these millimeter wave components may also be referred to as coupled line structures due to the close-proximity between the transmission lines used to form the building blocks of each component such as the millimeter wave filters and multiplexers.

Wide band signaling in millimeter wave frequencies is often limited by high dispersion, frequency dependent insertion losses and requirement of high gain transmit (Tx)- receive (Rx) baseband circuits. In order to overcome these limitations, band-limited signaling is often employed at millimeter wave frequencies. Bandpass filters with varying bandwidths and cut-off frequencies may be designed by cascading multiple resonator structures. Multiple bandpass filters may then be combined to obtain multiplexed solutions for high-density radiofrequency (RF) applications. With an increase in operational frequency, such as the millimeter wave frequencies, the component sizes reduce. Additionally, availability of area and lower losses compared to silicon substrates has led to integration of such filter and multiplexer structures on package. Integration into glass cores using the process described in FIG. 1 would lead to further reduction in the area occupied by such embedded components.

Package 200 may be a conventional flip chip assembled package that includes a glass core 202. Note that legacy millimeter wave components may be implemented on metal layers within the buildup layers 204, 206, in addition to the millimeter wave components 210, 212 within the glass core 202.

FIGs. 3A-3C illustrate a cross-section of different types of resonators within a glass core, in accordance with various embodiments. Resonator structures are transmission-line based structures where an abrupt change in impedance occurs at a resonance frequency. The change in impedance is invoked by selecting the length of the transmission line to be equivalent to specific wavelengths, for example a wavelength divided by 4 ( $\lambda/4$ ) at the desired resonance frequency. Note that in FIGs. 3A-3C, the $\lambda/4$ length is equal to the height of the core layer, although the height can also be shorter than the height of the core layer, depending on operation frequency. When more than one resonator structure is cascaded (not shown), standing waves will occur due to an overlap in the reflections caused by the abrupt impedance changes. Then, resonators with slightly different resonance frequencies can, for example, be cascaded to obtain bandpass filter implementations.

In filters, each of these resonator structures is designed to have a quarter wavelength of overlap with an adjacent resonator, although other overlap lengths such as lambda or lambda/8 etc. are also possible. At millimeter wave frequencies, the adjacent resonator structures require short coupling distances for example coupling distance 336, which may be between 10 - 40 $\mu$m. The laser-assisted etching processes described with respect to FIG. 1 can enable manufacturing of such coupling distances. Reducing the coupling distance between adjacent resonators would result in lower insertion loss and narrower bandwidths for bandpass filters. With a reduction in coupling distances, the overall area required for a bandpass filter would reduce. Then, multiple narrowband filters could be cascaded to obtain multiplexed solutions over different frequency ranges. Such designs would involve more detailed system architectures. FIG. 3A shows an example of a meander line resonator in a glass core 302, which may be similar to glass core 202 of FIG. 2, or maybe similar to glass core 106, 126, 146, 166 of FIG. 1. A conductive structure 320, which may be a via or a planar structure created using techniques described with respect to FIG. 1, may be filled with conductive material such as copper. The via/plane dimensions and distance to the adjacent reference ground plane would impact the impedance of each resonator structure. Conductive traces 322, 324 at opposite sides of the glass core 302 may be electrically coupled with the conductive structure 320. The resonator length would be dependent on the operational frequency of interest. Typically several such resonators would be cascaded to obtain other millimeter wave structures such as bandpass filters discussed above.

FIG. 3B shows a ring resonator according to the invention as defined by the appended claims, which has a first conductive structure 326 that is parallel to but not electrically coupled with a second conductive structure 328. In embodiments, both conductive structures 326, 328 extend from one side of the glass core 302 to the other side. Conductive traces 330, 332 are electrically coupled with the second conductive structure 328, in a direction away from the first conductive structure 326.

A third conductive structure 331 is electrically coupled with the conductive trace 330 and extends toward the center of the glass core 302. Similarly, a fourth conductive structure 334 is electrically coupled with the conductive trace 332 and extends toward the center of the glass core 302. In embodiments, while the third conductive structure 331 and the fourth conductive structure 334 are aligned, they do no directly physically and electrically couple with each other. In embodiments, the third conductive structure 331 and the fourth conductive structure 334 may be vias or a planar conductive structure. The other features 330, 332, 328 and 326 would also be identical, either vias or planar structures.

A coupling distance 336 between the first conductive structure 326 and the second conductive structure 328 may be varied to control the energy coupled between conductive structures 326 and 328. Once energy enters conductive structure 328, it would travel in 330, 331,332, 334. The energy would travel back and forth and once the waves in the resonator loop acquire a phase difference that is a multiple of $2\pi$, the waves would interfere either constructively or destructively. This is described as a condition of resonance. Ring resonators are often used as notch filters for optical or millimeter wave applications. The loop length is then controlled to the desired resonance frequency from the resonator.

FIG. 3C shows an example of a hairpin resonator, which has a first conductive structure 340 and the second conductive structure 342 that extend from a first side to a second side of the glass core 302. A length of the conductive structures 340, 342 may determine a resonance frequency, for example the overlap length between adjacent resonators would be one fourth of the wavelength ( $\lambda/4$ ). The conductive structures 340, 342 need to be electrically coupled at a side of the glass core 302 by a conductive trace 344. Several such hairpin resonators can be cascaded to form filters with varying filter orders and bandwidths. Hairpin resonators are commonly used for bandpass response in millimeter wave frequencies.

For the embodiments described in FIGs. 3A-3C, the various conductive structures may include vias or a planar structures created using techniques and processes described above with respect to FIG. 1.

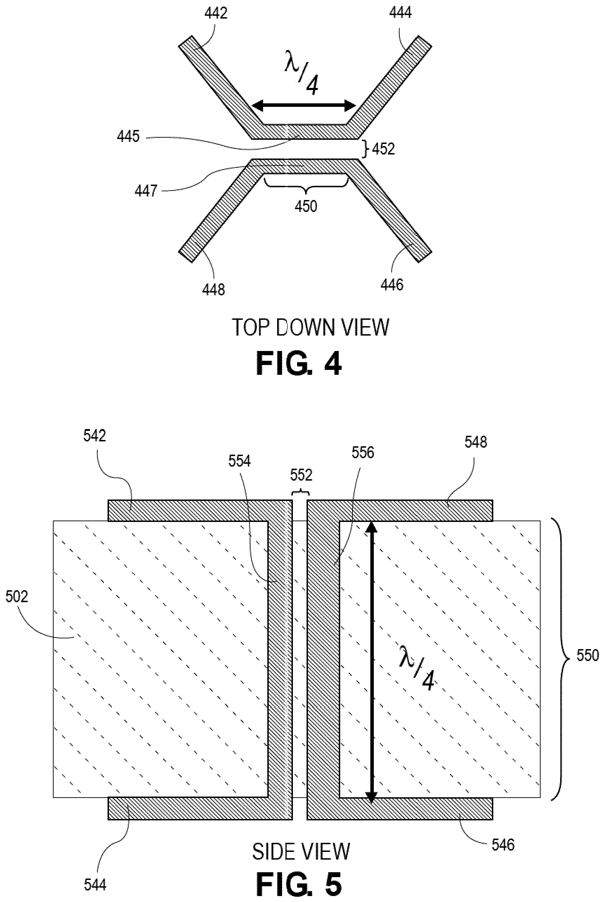

FIGs. 4-5 include embodiments of directional couplers. A directional coupler may be a four-port device where power from one port to another port can be coupled into yet another port. The amount of power coupled depends on a coupling factor which is the ratio of the coupled power to the input power in dB. For a transmission line implementation, coupled lines are used to obtain directional couplers. Here, the coupling or signal overlap occurs when two transmission lines are placed near one another so that energy can transfer from one line to another. Usually, the coupling occurs over a coupling length of $\lambda/4$. FIG. 4 illustrates a top view example of a conventional strip line implementation of a directional coupler. The directional coupler of FIG. 4 may be implemented in a buildup layer or a redistribution layer (RDL), such as buildup layer 204, 206 of FIG. 2.

This legacy implementation includes four ports, port 1 442, port 2 444, port 3 446, and port 4 448. Port 1 442 may be electrically coupled with port 2 444 with a conductive section 445, and port 3 446 may be electrically coupled with port 4 448 using conductive section 447. A length 450 of the conductive sections 445, 447 may be selected to correspond to a particular coupling length corresponding to a wavelength, for example, a length of $\lambda/4$. In embodiments, the conductive sections 445, 447 may be separated by a space 452. When the input power is applied to port 1 442, the power is transmitted to port 2 444 and the power also appears at port 4 448. Port 3 446 remains isolated. The power coupled into port 4 448 provides a way to tap into the frequency and power level of the signal without interfering with the actual transmitted signal. Additionally, since the ports are identical, any port can be used as an input port. The coupled response is periodic with multiples of n lambda/4, with n being an odd number.

FIG. 5 illustrates a side view of a directional coupler within a glass core, in accordance with various embodiments. The directional coupler of FIG. 5 may be created using the techniques described above with respect to FIG. 1.

A first conductive structure 554 and a second conductive structure 556 may be made through a glass core 502. The first conductive structure 554 and the second conductive structure 556 may be substantially parallel, not be an electrical contact, and separated by a distance 552. Besides the coupling length, the coupling distance 552 determines if the energy would couple over from the input port to the coupled port. Hence, it is critical that the distance is small, in practice the traces may be separated by a few micrometers. In embodiments, a length 550 of the first conductive structure 554 and the second conductive structure 556 may be selected to correspond to a particular coupling length that corresponds to a wavelength, for example, a length of $\lambda/4$. In embodiments, the first conductive structure 554 and the second conductive structure 556 may be a via or a planar structure filled with conductive material, such as copper.

A conductive trace 542 may be electrically and physically coupled with the first conductive structure 554 at a top of the glass core 502. A conductive trace 544 may be electrically and physically coupled with the first conductive structure 554 at a bottom of the glass core 502. Similarly, a conductive trace 548 may be electrically and physically coupled with the second conductive structure 556 at a top of the glass core 502. The conductive trace 546 may be electrically and physically coupled with the second conductive structure 556 at the bottom of the glass core 502.

In embodiments, adjacent vertical ground planes may exist around the structure. These planes would act as reference ground planes. The distance between the trace and the ground plane could vary between 20 $\mu$m 200 $\mu$m. This distance would depend upon the impedance required for the transmission lines, typically 50 ohms. Note that if needed angled lasers can be used to obtain tapered feed lines. However, the critical aspect for the directional couplers is obtaining minimum coupling distance and ensuring that the length to be a quarter wavelength at the desired frequency.

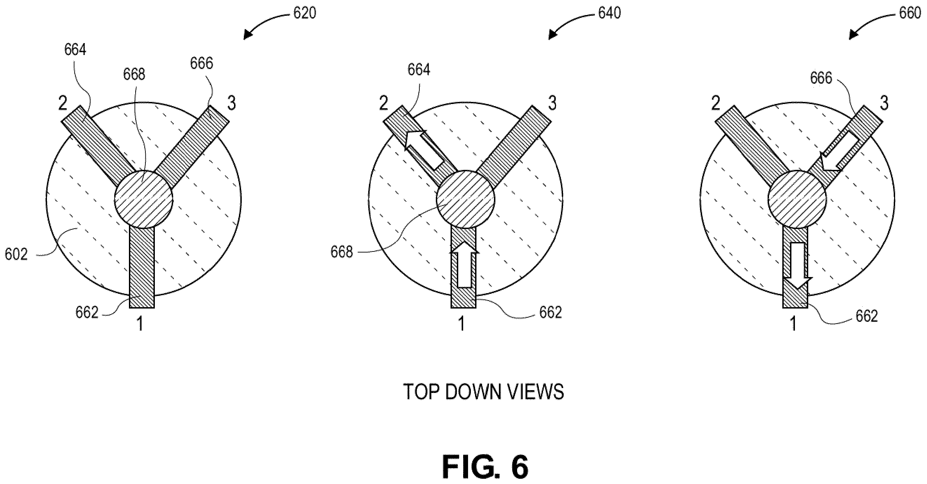

FIG. 6 illustrates top views of a circulator that includes a ferrite and strip line junction with examples of circulation of an input signal, in accordance with various embodiments.

Circulators may be used for power transfer from one port to another. Circulators are non-reciprocal devices, where power transfer can occur in one direction from one port to another. Circulators may provide good interfaces for transmit/receive operations in antennas or signal launchers used at millimeter wave frequencies and are used in radar applications. In order to obtain non-reciprocity, circulator devices make use of magnets and ferrites.

Circulator 620 has three ports, port 1 662, port 2 664, and port 3 666 within a glass core 602. These ports may be implemented as strip lines, and may come together at a ferrite junction 668. Referring now to circulator 640, when a signal is applied to port 1 662 and there is a magnetic field present at the ferrite junction 668, the signal appears at port 2 664. Similarly, referring to circulator 660, if a signal is applied at port 3 666, the output would appear at port 1 662, and the like.

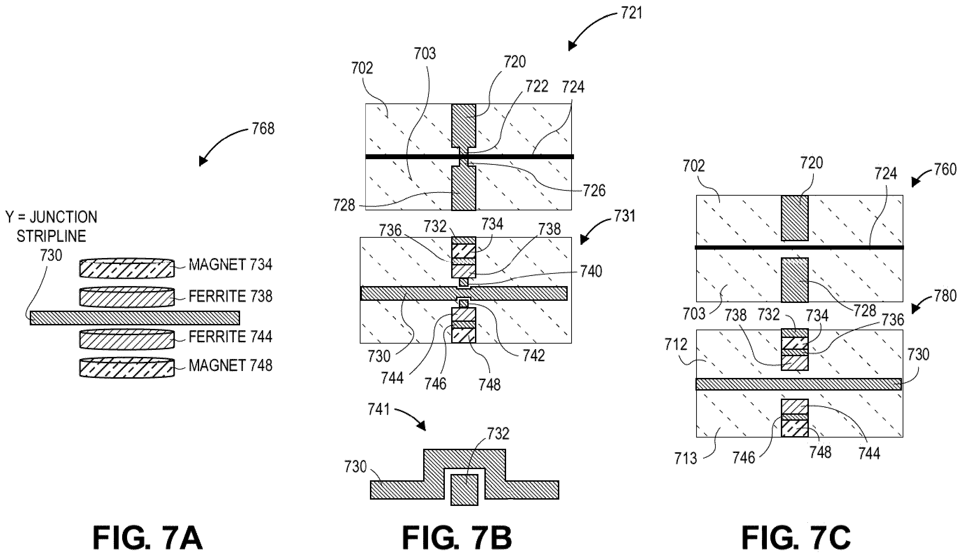

A ferrite based circulator operation entails control of the forward and reverse propagating waves, which may be referred to as circularly polarized counter-rotating waves, based on the applied biasing field. The velocity of either wave can be controlled by appropriate selection of ferrite materials and biasing magnetic field between magnet 734 and 748 within the ferrite junction 768, described in more detail with respect to FIGs. 7A-7C. Hence, the propagating waves can interfere constructively at one port and destructively at another port. Note that the termination of one of the ports, for example port number 2 664, will lead to obtaining another millimeter wave structure, the isolator. The isolator is a two-port device that allows for unidirectional flow of power. Thus, it is often used as a way to protect devices from mismatches or sudden impedance variations. In essence they would be used to prevent detuning of millimeter wave devices such as antennas from mismatched loads.

FIGs. 7A-7C illustrate various portions within a process of creating a circulator, in accordance with various embodiments. FIG. 7A shows a cross-section of a ferrite junction 768, which may be similar to ferrite junction 668 of FIG. 6. The ferrite junction 768 includes a junction strip line 730, which may be similar to strip lines used for ports 662, 664, 666 of FIG. 6, a first ferrite layer 738 above the junction strip line 730, and a first magnet layer 734 above the first ferrite layer 738. Similarly, the ferrite junction 768 may also include a second ferrite layer 744 below the junction strip line 730, and a second magnet layer 748 below the second ferrite layer 744. The thickness of the ferrite films (first ferrite layer 738, first magnet layer 734, second ferrite layer 744, second magnet layer 748, may typically vary between 10 nm - 15 $\mu$m. In embodiments, thicker layers may be preferred in order to ensure sufficient magnetization occurs and also due to ease in manufacturing.

FIG. 7B shows two stages of manufacturing a circulator, in accordance with embodiments. The first stage 721 shows a first glass layer 702 that may be coupled with a second glass layer 703 and bonded at line 724. Prior to bonding, vias 720 and 722 may be etched within the first glass layer 702, and vias 726 and 728 etched within the second glass layer 703 using techniques described above with respect to FIG. 1. The second stage 731 shows a strip line 730, which may be placed on a surface of the first glass layer 702 or the second glass layer 703 prior to bonding. Conductive material 740 may be inserted into etched via 722, and conductive material 742 may be inserted into etched via 726, where conductive material 740, 742 are electrically coupled with the strip line 730. A ferrite layer 738, a spacer layer 736, a magnet layer 734, and another spacer layer 732 may be placed in the etched via 720, and a ferrite layer 744, spacer 746, and magnet 748 may be placed within etched via 728. Diagram 741 shows a top view of the strip line 730 and the spacer layer 732.

FIG. 7C, which may be similar to FIG. 7B, includes a first stage 760 which may be similar to first stage 721 of FIG. 7B, and includes a second stage 780 which may be similar to second stage 731 of FIG. B. However, unlike FIG. 7B, there is no etched via 722 in the first glass layer 702 and there is no etched via 726 in the second glass layer 703. In embodiments, the features in the first glass layer 702 and the second glass layer 703 may be formed using the laser-assisted etching process described above with respect to FIG. 1.

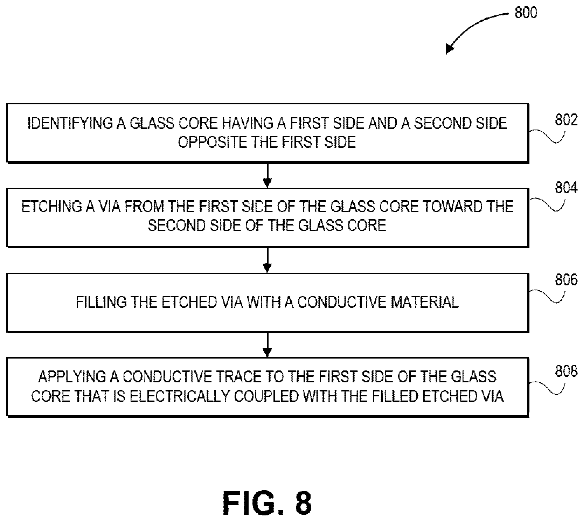

FIG. 8 illustrates an example process to create a resonator in a glass core, in accordance with various embodiments. Process 800 may be performed by one or more processes, techniques, apparatus, or systems described herein and in particular with respect to FIGs. 1-7C.

At block 802, the process may include identifying a glass core having a first side and a second side opposite the first side. In embodiments, the glass core may be similar to glass core 106, 126, 146, 166 of FIG. 1, glass core 202 of FIG. 2, or of glass core 302 of FIGs. 3A-3C.

At block 804, the process may further include etching a via from the first side of the glass core toward the second side of the glass core. In embodiments, the etched via may be similar to the via used to create conductive structure 320 of FIG. 3A.

At block 806, the process may further include filling the etched via with a conductive material. In embodiments, the conductive material may be similar to conductive material used in conductive via 320 of FIG. 3A.

At block 808, the process may further include applying a conductive trace to the first side of the glass core that is electrically coupled with the filled etched via. In embodiments, the conductive trace may be similar to conductive trace 324, or conductive trace 322 of FIG. 3A. It is also possible to create this conductive trace using a blind via process and then filling the top region with other materials. Implying that this process flow is not definitive, and it might be modified.

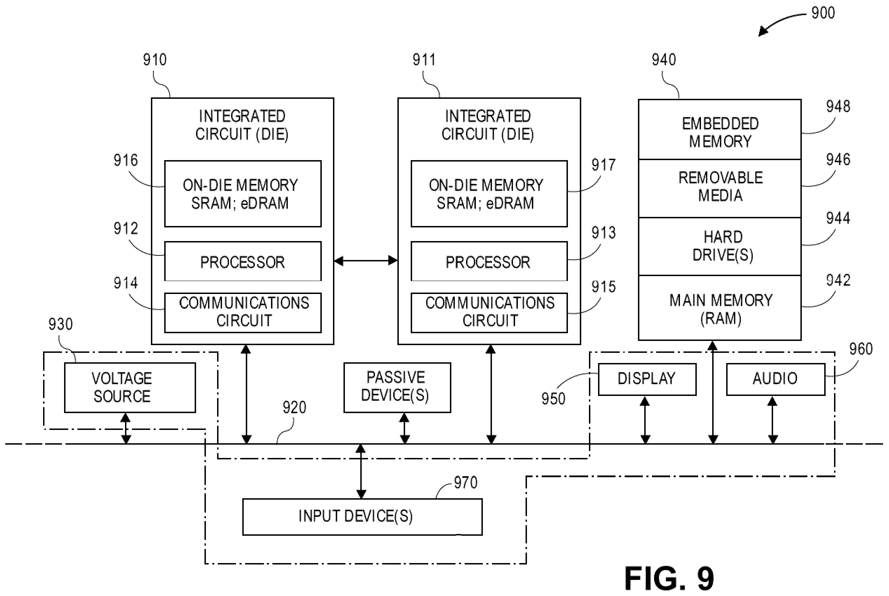

FIG. 9 schematically illustrates a computing device, in accordance with various embodiments. The computer system 900 (also referred to as the electronic system 900) as depicted can embody all or part of millimeter wave components in a glass core of a substrate, according to any of the several disclosed embodiments and their equivalents as set forth in this disclosure. The computer system 900 may be a mobile device such as a netbook computer. The computer system 900 may be a mobile device such as a wireless smart phone. The computer system 900 may be a desktop computer. The computer system 900 may be a hand-held reader. The computer system 900 may be a server system. The computer system 900 may be a supercomputer or high-performance computing system.

In an embodiment, the electronic system 900 is a computer system that includes a system bus 920 to electrically couple the various components of the electronic system 900. The system bus 920 is a single bus or any combination of busses according to various embodiments. The electronic system 900 includes a voltage source 930 that provides power to the integrated circuit 910. In some embodiments, the voltage source 930 supplies current to the integrated circuit 910 through the system bus 920.

The integrated circuit 910 is electrically coupled to the system bus 920 and includes any circuit, or combination of circuits according to an embodiment. In an embodiment, the integrated circuit 910 includes a processor 912 that can be of any type. As used herein, the processor 912 may mean any type of circuit such as, but not limited to, a microprocessor, a microcontroller, a graphics processor, a digital signal processor, or another processor. In an embodiment, the processor 912 includes, or is coupled with, all or part of signal and ground vias in a glass core to control impedance, as disclosed herein. In an embodiment, SRAM embodiments are found in memory caches of the processor. Other types of circuits that can be included in the integrated circuit 910 are a custom circuit or an application-specific integrated circuit (ASIC), such as a communications circuit 914 for use in wireless devices such as cellular telephones, smart phones, pagers, portable computers, two-way radios, and similar electronic systems, or a communications circuit for servers. In an embodiment, the integrated circuit 910 includes on-die memory 916 such as static random-access memory (SRAM). In an embodiment, the integrated circuit 910 includes embedded on-die memory 916 such as embedded dynamic random-access memory (eDRAM).

In an embodiment, the integrated circuit 910 is complemented with a subsequent integrated circuit 911. Useful embodiments include a dual processor 913 and a dual communications circuit 915 and dual on-die memory 917 such as SRAM. In an embodiment, the dual integrated circuit 910 includes embedded on-die memory 917 such as eDRAM.

In an embodiment, the electronic system 900 also includes an external memory 940 that in turn may include one or more memory elements suitable to the particular application, such as a main memory 942 in the form of RAM, one or more hard drives 944, and/or one or more drives that handle removable media 946, such as diskettes, compact disks (CDs), digital variable disks (DVDs), flash memory drives, and other removable media known in the art. The external memory 940 may also be embedded memory 948 such as the first die in a die stack, according to an embodiment.

In an embodiment, the electronic system 900 also includes a display device 950, an audio output 960. In an embodiment, the electronic system 900 includes an input device such as a controller 970 that may be a keyboard, mouse, trackball, game controller, microphone, voice-recognition device, or any other input device that inputs information into the electronic system 900. In an embodiment, an input device 970 is a camera. In an embodiment, an input device 970 is a digital sound recorder. In an embodiment, an input device 970 is a camera and a digital sound recorder.

As shown herein, the integrated circuit 910 can be implemented in a number of different embodiments, including all or part of millimeter wave components in a glass core of a substrate, according to any of the several disclosed embodiments and their equivalents, an electronic system, a computer system, one or more methods of fabricating an integrated circuit, and one or more methods of fabricating an electronic assembly that includes a package substrate implementing all or part of millimeter wave components in a glass core of a substrate, according to any of the several disclosed embodiments as set forth herein in the various embodiments and their art-recognized equivalents. The elements, materials, geometries, dimensions, and sequence of operations can all be varied to suit particular I/O coupling requirements including array contact count, array contact configuration for a microelectronic die embedded in a processor mounting substrate according to any of the several disclosed processes used for signal and ground vias in a glass core to control impedance embodiments and their equivalents. A foundation substrate may be included, as represented by the dashed line of FIG. 9. Passive devices may also be included, as is also depicted in FIG. 9.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

## Claims

1. A ring resonator comprising:

   a glass core (302) having a first side and a second side opposite the first side; and
   a conductive structure (326) within the glass core (302) extending from the first side of the glass core toward the second side of the glass core, wherein a length of the conductive structure (326) corresponds with a resonance frequency,
   wherein the conductive structure (326) is a first conductive structure (326) that extends from the first side of the glass core (302) to the second side of the glass core (302); and wherein the ring resonator further comprises:

   a second conductive structure (328) that extends from the first side of the glass core (302) to the second side of the glass core (302), wherein the second conductive structure (328) is substantially parallel to the first conductive structure (326) and not electrically coupled with the first conductive structure (326), wherein the second conductive structure (328) and the first conductive structure (326) are separated by a coupling distance (336);
   a third conductive structure (331, 334) that extends from the first side of the glass core (302) to the second side of the glass core (302), wherein a first part (331) of the third conductive structure (331, 334) extends from the first side of the glass core (302) toward the second side of the glass core (302), and wherein a second part (334) of the third conductive structure (331, 334) extends from the second side of the glass core (302) toward the first side of the glass core (302), wherein the first part (331) and the second part (334) are aligned with each other and separated by a nonconductive material:

and

wherein the first part (331) of the third conductive structure (331, 334) is electrically coupled with the second conductive structure (328) at the first side of the glass core (302) with a first conductive trace (330), and wherein the second part (334) of the third conductive structure (331, 334) is electrically coupled with the second conductive structure (328) at the second side of the glass core (302) with a second conductive trace (332).

2. The ring resonator of claim 1, wherein the first conductive structure (326) is a selected one of: a conductive via or a conductive plane.

3. The ring resonator of claim 1 or claim 2, wherein the coupling distance (336) is related with a resonance frequency.

4. The ring resonator of any one preceding claim wherein the coupling distance (336) between the first conductive structure (326) and the second conductive structure (328) is between 10 and 40 micrometres.

5. A method for a ring resonator, the method comprising:

identifying a glass core (302) having a first side and a second side opposite the first side;
forming a first conductive structure (326) extending from the first side of the glass core (302) to the second side of the glass core (302);
etching a via extending from the first side of the glass core (302) to the second side of the glass core (302);
filling the etched via with a conductive material to provide a second conductive structure (328) parallel to the first conductive structure (326);
applying a first conductive trace (330) to the first side of the glass core (302) that is electrically coupled with the filled etched via (328);
applying a second conductive trace (332) to the second side of the glass core (302) that is electrically coupled to the filled etched via (328);
forming a third conductive structure (331) extending from the first side of the glass core (302) towards the centre of the glass core (302), wherein the third conductive structure (331) is electrically coupled to the first conductive trace (330); and
forming a fourth conductive structure (334) extending from the second side of the glass core (302) towards the centre of the glass core (302), wherein the fourth conductive structure (334) is electrically coupled to the second conductive trace (332),
wherein the third conductive structure (331) and the fourth conductive structure (334) are aligned with each other and separated by a nonconductive material,
wherein the first and second conductive structures (326, 328) are not electrically coupled to each other and wherein the first and second conductive structures (326, 328) are separated by a coupling distance (336).

6. The method of claim 5, wherein the conductive material includes a selected one of:
copper, gold, or aluminum.

7. The method of claim 5 or claim 6 wherein the coupling distance (336) is related with a resonance frequency.

8. The method of any one of claims 5 to 7, wherein the coupling distance (336) is between 10 and 40 micrometres.

**Patentansprüche**

1. Ringresonator, der Folgendes umfasst:

einen Glaskern (302) mit einer ersten Seite und einer der ersten Seite gegenüberliegenden zweiten Seite; und
eine leitfähige Struktur (326) innerhalb des Glaskerns (302), die sich von der ersten Seite des Glaskerns in Richtung der zweiten Seite des Glaskerns erstreckt, wobei eine Länge der leitfähigen Struktur (326) einer Resonanzfrequenz entspricht,
wobei die leitfähige Struktur (326) eine erste leitfähige Struktur (326) ist, die sich von der ersten Seite des Glaskerns (302) zu der zweiten Seite des Glaskerns (302) erstreckt; und wobei der Ringresonator ferner Folgendes umfasst:

eine zweite leitfähige Struktur (328), die sich von der ersten Seite des Glaskerns (302) zu der zweiten Seite des Glaskerns (302) erstreckt, wobei die zweite leitfähige Struktur (328) im Wesentlichen parallel zu der ersten leitfähigen Struktur (326) ist und nicht elektrisch mit der ersten leitfähigen Struktur (326) gekoppelt ist, wobei die zweite leitfähige Struktur (328) und die erste leitfähige Struktur (326) durch einen Kopplungsabstand (336) getrennt sind; eine dritte leitfähige Struktur (331, 334), die sich von der ersten Seite des Glaskerns (302) zu der zweiten Seite des Glaskerns (302) erstreckt, wobei sich ein erster Teil (331) der dritten leitfähigen Struktur (331, 334) von der ersten Seite des Glaskerns (302) zu der zweiten Seite des Glaskerns (302) erstreckt und wobei sich ein zweiter Teil (334) der dritten leitfähigen Struktur (331, 334) von der zweiten Seite des Glaskerns (302) in Richtung der ersten Seite des Glaskerns (302) erstreckt, wobei der erste Teil (331) und der zweite Teil (334) miteinander ausgerichtet und durch ein nichtleitfähiges Material getrennt sind; und wobei der erste Teil (331) der dritten leitfähigen Struktur (331, 334) an der ersten Seite des Glaskerns (302) mit einer ersten Leiterbahn (330) elektrisch mit der zweiten leitfähigen Struktur (328) gekoppelt ist und wobei der zweite Teil (334) der dritten leitfähigen Struktur (331, 334) an der zweiten Seite des Glaskerns (302) mit einer zweiten Leiterbahn (332) elektrisch mit der zweiten leitfähigen Struktur (328) gekoppelt ist.

2. Ringresonator nach Anspruch 1, wobei die erste leitfähige Struktur (326) ein ausgewähltes von Folgendem ist: ein leitfähiges Via oder eine leitfähige Ebene.

3. Ringresonator nach Anspruch 1 oder Anspruch 2, wobei der Kopplungsabstand (336) mit einer Resonanzfrequenz in Beziehung steht.

4. Ringresonator nach einem der vorhergehenden Ansprüche, wobei der Kopplungsabstand (336) zwischen der ersten leitfähigen Struktur (326) und der zweiten leitfähigen Struktur (328) zwischen 10 und 40 Mikrometer beträgt.

5. Verfahren für einen Ringresonator, wobei das Verfahren Folgendes umfasst:

Identifizieren eines Glaskerns (302) mit einer ersten Seite und einer der ersten Seite gegenüberliegenden zweiten Seite; Bilden einer ersten leitfähigen Struktur (326), die sich von der ersten Seite des Glaskerns (302) zu der zweiten Seite des Glaskerns (302) erstreckt; Ätzen eines Vias, das sich von der ersten Seite des Glaskerns (302) zu der zweiten Seite des Glaskerns (302) erstreckt; Füllen des geätzten Vias mit einem leitfähigen Material, um eine zweite leitfähige Struktur (328) parallel zu der ersten leitfähigen Struktur (326) bereitzustellen; Aufbringen einer ersten Leiterbahn (330) auf die erste Seite des Glaskerns (302), die elektrisch mit dem gefüllten geätzten Via (328) gekoppelt ist; Aufbringen einer zweiten Leiterbahn (332) auf die zweite Seite des Glaskerns (302), die elektrisch mit dem gefüllten geätzten Via (328) gekoppelt ist; Bilden einer dritten leitfähigen Struktur (331), die sich von der ersten Seite des Glaskerns (302) in Richtung der Mitte des Glaskerns (302) erstreckt, wobei die dritte leitfähige Struktur (331) elektrisch mit der ersten Leiterbahn (330) gekoppelt ist; und Bilden einer vierten leitfähigen Struktur (334), die sich von der zweiten Seite des Glaskerns (302) in Richtung der Mitte des Glaskerns (302) erstreckt, wobei die vierte leitfähige Struktur (334) elektrisch mit der zweiten Leiterbahn (332) gekoppelt ist, wobei die dritte leitfähige Struktur (331) und die vierte leitfähige Struktur (334) miteinander ausgerichtet und durch ein nichtleitfähiges Material getrennt sind, wobei die erste und die zweite leitfähige Struktur (326, 328) nicht elektrisch miteinander gekoppelt sind und wobei die erste und die zweite leitfähige Struktur (326, 328) durch einen Kopplungsabstand (336) getrennt sind.

6. Verfahren nach Anspruch 5, wobei das leitfähige Material Kupfer, Gold oder Aluminium beinhaltet.

7. Verfahren nach Anspruch 5 oder Anspruch 6, wobei der Kopplungsabstand (336) mit einer Resonanzfrequenz in Beziehung steht.

8. Verfahren nach einem der Ansprüche 5 bis 7, wobei der Kopplungsabstand (336) zwischen 10 und 40 Mikrometer beträgt.

## Revendications

1. Résonateur annulaire comprenant :

un noyau de verre (302) dotée d'un premier côté et d'un second côté à l'opposé du premier côté ; et une structure conductrice (326) à l'intérieur du noyau de verre (302) s'étendant du premier côté du noyau de verre vers le second côté du noyau de verre, une longueur de la structure conductrice (326) correspondant à une fréquence de résonance,

la structure conductrice (326) étant une première structure conductrice (326) qui s'étend du premier côté du noyau de verre (302) jusqu'au second côté du noyau de verre (302) ; et le résonateur annulaire comprenant en outre :

une deuxième structure conductrice (328) qui s'étend du premier côté du noyau de verre (302) au second côté du noyau de verre (302), la deuxième structure conductrice (328) étant sensiblement parallèle à la première structure conductrice (326) et non couplée électriquement à la première structure conductrice (326), la deuxième structure conductrice (328) et la première structure conductrice (326) étant séparées par une distance de couplage (336) ;

une troisième structure conductrice (331, 334) qui s'étend du premier côté du noyau de verre (302) au second côté du noyau de verre (302), une première partie (331) de la troisième structure conductrice (331, 334) s'étendant du premier côté du noyau de verre (302) vers le second côté du noyau de verre (302), et une seconde partie (334) de la troisième structure conductrice (331, 334) s'étendant depuis le second côté du noyau de verre (302) vers le premier côté du noyau de verre (302), la première partie (331) et la seconde partie (334) étant alignées l'une avec l'autre et séparées par un matériau non conducteur ; et

la première partie (331) de la troisième structure conductrice (331, 334) étant couplée électriquement à la deuxième structure conductrice (328) au niveau du premier côté du noyau de verre (302) avec une première trace conductrice (330), et la seconde partie (334) de la troisième structure conductrice (331, 334) étant couplée électriquement à la deuxième structure conductrice (328) au niveau du second côté du noyau de verre (302) avec une seconde trace conductrice (332).

2. Résonateur annulaire selon la revendication 1, la première structure conductrice (326) étant une structure sélectionnée parmi : un trou d'interconnexion conducteur ou un plan conducteur.

3. Résonateur annulaire selon la revendication 1 ou la revendication 2, la distance de couplage (336) étant liée à une fréquence de résonance.

4. Résonateur annulaire selon l'une quelconque des revendications précédentes, la distance de couplage (336) entre la première structure conductrice (326) et la deuxième structure conductrice (328) étant comprise entre 10 et 40 micromètres.

5. Procédé pour un résonateur annulaire, le procédé comprenant :

l'identification d'un noyau de verre (302) doté d'un premier côté et d'un second côté à l'opposé du premier côté ;

la formation d'une première structure conductrice (326) s'étendant depuis le premier côté du noyau de verre (302) jusqu'au second côté du noyau de verre (302) ;

la gravure d'un trou d'interconnexion s'étendant depuis le premier côté du noyau de verre (302) jusqu'au second côté du noyau de verre (302) ;

le remplissage du trou d'interconnexion gravé avec un matériau conducteur pour fournir une deuxième structure conductrice (328) parallèle à la première structure conductrice (326) ;

l'application d'une première trace conductrice (330) sur le premier côté du noyau de verre (302) électriquement couplée avec le trou d'interconnexion gravé rempli (328), l'application d'une seconde trace conductrice (332) sur le second côté du noyau de verre (302) électriquement couplée au trou d'interconnexion gravé rempli (328),

la formation d'une troisième structure conductrice (331) s'étendant du premier côté du noyau de verre (302) vers le centre du noyau de verre (302), la troisième structure conductrice (331) étant couplée électriquement à la première trace conductrice (330) ; et

la formation d'une quatrième structure conductrice (334) s'étendant du second côté du noyau de verre (302) vers le centre du noyau de verre (302), la quatrième structure conductrice (334) étant couplée électriquement à la seconde trace conductrice (332),

la troisième structure conductrice (331) et la quatrième structure conductrice (334) étant alignées l'une avec l'autre et séparées par un matériau non conducteur,

les première et deuxième structures conductrices (326, 328) n'étant pas couplées électriquement l'une à l'autre et les première et deuxième structures conductrices (326, 328) étant séparées par une distance de couplage (336).

6. Procédé selon la revendication 5, le matériau conducteur comprenant un matériau sélectionné parmi : le cuivre, l'or ou l'aluminium.

**7.** Procédé selon la revendication 5 ou la revendication 6, la distance de couplage (336) étant liée à une fréquence de résonance.

**8.** Procédé selon l'une quelconque des revendications 5 à 7, la distance de couplage (336) étant comprise entre 10 et 40 micromètres.

FIG. 1

EP 4 106 099 B1

**FIG. 2**

FIG. 3A          FIG. 3B          FIG. 3C

442    444

445

$\lambda/4$

}452

447

450

448    446

TOP DOWN VIEW

**FIG. 4**

542    554    552    556    548

502    $\lambda/4$    550

544    SIDE VIEW    546

**FIG. 5**

FIG. 6

TOP DOWN VIEWS

**FIG. 7A**

**FIG. 7B**

**FIG. 7C**

EP 4 106 099 B1

IDENTIFYING A GLASS CORE HAVING A FIRST SIDE AND A SECOND SIDE OPPOSITE THE FIRST SIDE — 802

ETCHING A VIA FROM THE FIRST SIDE OF THE GLASS CORE TOWARD THE SECOND SIDE OF THE GLASS CORE — 804

FILLING THE ETCHED VIA WITH A CONDUCTIVE MATERIAL — 806

APPLYING A CONDUCTIVE TRACE TO THE FIRST SIDE OF THE GLASS CORE THAT IS ELECTRICALLY COUPLED WITH THE FILLED ETCHED VIA — 808

**FIG. 8**

**FIG. 9**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20140361854 A1
- US 20170186710 A1
- US 2010096174 A1

### Non-patent literature cited in the description

- Millimeter-wave/THz passive components design using through silicon via (TSV) technology. **SANMING HU et al.** ELECTRONIC COMPONENTS AND TECHNOLOGY CONFERENCE (ECTC), 2010 PROCEEDINGS 60. IEEE, 01 June 2010, 520-523